(19) Europäisches Patentamt
European Patent Office
Office européen des brevets

(11) Publication number: **0 423 689 A2**

(12) **EUROPEAN PATENT APPLICATION**

(21) Application number: **90119755.8**

(22) Date of filing: **15.10.90**

(51) Int. Cl.[5]: **C08G 77/48**, C08L 83/14, C08J 5/24, H05K 1/03

(30) Priority: **16.10.89 US 422214**

(43) Date of publication of application: **24.04.91 Bulletin 91/17**

(84) Designated Contracting States: **BE DE ES FR GB IT NL SE**

(71) Applicant: **HERCULES INCORPORATED**
**Hercules Plaza**
**Wilmington Delaware 19894(US)**

(72) Inventor: **Bard, John Kenneth**
**3210 Addison Drive, Brandywine Springs Manor**
**Wilmington, Delaware 19808(US)**
Inventor: **Burnier, Julia Schmidt**
**5902 Stone Pine Road**
**Wilmington, Delaware 19808(US)**

(74) Representative: **Lederer, Franz, Dr. et al**
**Lederer, Keller & Riederer, Patentanwälte,**
**Lucile-Grahn-Strasse 22**
**W-8000 München 80(DE)**

(54) **Organosilicon materials.**

(57) A process for preparing a prepreg that comprises reacting a polycyclic polyene comprising dicyclopentadiene with a cyclic polysiloxane having three or more hydrogen atoms bound to silicon, and the polyene and the polysiloxane are reacted with a chain extender comprising at least one polyene having at least two non-aromatic, non-conjugated carbon-carbon double bonds highly reactive in hydrosilation to produce a prepolymer comprising a polycyclic polyene residue and a cyclic polysiloxane residue linked through carbon-silicon bonds, and the reaction is continued until the prepolymer has a viscosity of 300 to 3,000 centipoise at 100 °C and has 65% to about 75% of the available ≡SiH groups of the cyclic polysiloxane reacted, impregnating a fiber reinforcing material with the prepolymer, and heating the impregnated material to cure the prepolymer.

EP 0 423 689 A2

# ORGANOSILICON MATERIALS

This invention relates to a process for preparing prepregs for printed circuit boards. The invention is also directed to the prepregs made by the process and use of such prepregs to make laminates and printed circuit boards.

Printed circuit boards on which electronic devices are to be mounted are generally made from laminated polymeric material on which the interconnections for the devices are printed. If the interconnections are formed by removing non-printed areas, the laminates may be clad with the conductive material, such as copper foil. The laminates may be reinforced with paper or woven or non-woven fibers of glass, quartz, aramids, or graphite.

Circuit boards for advanced electronic applications must have high levels of thermal, electrical and physical properties. For instance, the polymeric material used should preferably have a high glass transition temperature (Tg), a low thermal expansion coefficient, a low dielectric constant, and high moisture resistance.

The polymers should also be adapted for conventional processing used in the circuit board industry. Circuit board laminate is conventionally fabricated from prepregs made of the reinforcing material impregnated with the partially cured polymer (prepolymer). The reinforcement (usually a fabric) is passed continuously through liquid prepolymer.

Laminates are conventionally formed by stacking individual plies of prepreg and laminating them under heat and pressure in a hydraulic press. If circuitry is to be formed via a subtractive process, a conductive layer, typically copper foil, is laminated to one or both sides of the laminate during this operation. Circuit boards may have circuitry on one or both sides of the laminate, and multilayer circuit boards may have contain circuitry on both external and internal layers, formed by bonding together in a second lamination step thin laminates that already have circuitry, using prepreg as an adhesive dielectric layer. Additional curing ("post-cure") at an elevated temperature may be required to fully cure the polymer.

The melt viscosity of the prepolymer during lamination must be low enough to allow some degree of flow during lamination, to allow for consolidation of the individual plies of the prepreg into a unified laminate and to allow for elimination of trapped air or volatiles, but it should not be so low that excessive distortion occurs.

The prepolymer content (weight percent prepolymer) is influenced by factors such as the solids content of the solution, the mechanical arrangement of the impregnation device (called a treater), and the viscosity of the resin. Depending on the nature of the reinforcement being used, a desirable prepolymer content may be between about 35% to about 15%. For each specific reinforcing material, such as a specific style of woven glass cloth, the proper prepolymer content must be determined to within a range of a few percentage points in order to allow for proper performance in subsequent processing steps and during circuit board operation, so control of prepolymer content is important.

Also, since the polymer serves as a dielectric layer, there must be sufficient polymer between conductive layers to maintain the dielectric strength required to prevent failure of the board during operation. In some instances, the electrical performance of the circuit board can be affected by the thickness of the dielectric layer, which can be determined by controlling the prepolymer content.

U.S. Patents 4,900,779 and 4,902,731 describe organosilicon polymers and prepolymers comprised of alternating polycyclic hydrocarbon residues and cyclic polysiloxane or tetrahedral siloxysilane residues linked thru carbon-silicon bonds. They are made from polycyclic polyenes having at least two chemically distinguishable non-aromatic carbon-carbon double bonds (such as dicyclopentadiene and cyclopentadiene trimer) and cyclic siloxanes. The prepolymers generally have 30 to 65 % of the hydrosilane groups reacted. Two of the examples mention thermoset test pieces made by molding prepolymers comprising dicyclopentadiene, cyclopentadiene trimer and tetramethylcyclotetrasiloxane and curing with heat.

In connection with the manufacture of printed circuit boards, there is a need for more efficient preparation, with a wide variety of fiber reinforcing materials, of prepregs and laminates. That requires improvements in prepolymers, to ensure that the resin viscosity is maintained during fabrication of the prepregs, thus avoiding any tendency for the prepolymer to drip off the reinforcement, permitting better control of prepolymer content. In addition, there is a need for better control of the flow of the prepolymer during lamination.

According to the invention, a process for preparing a prepreg that comprises reacting a polycyclic polyene comprising dicyclopentadiene with a cyclic polysiloxane having two or more hydrogen atoms bound to silicon, to produce a prepolymer comprising a polycyclic polyene residue and a cyclic polysiloxane residue linked through carbon-silicon bonds, impregnating a fiber reinforcing material with the

prepolymer, and heating the impregnated material solution to cure the prepolymer, is characterized in that the cyclic polysiloxane has three or more hydrogen atoms bound to silicon, and the polyene and the polysiloxane are reacted with a chain extender comprising at least one polyene having at least two non-aromatic, non-conjugated carbon-carbon double bonds highly reactive in hydrosilation, the carbon-carbon double bonds being either in an alpha, beta or gamma position on a linear carbon moiety, next to two bridgehead positions in a strained polycyclic aliphatic ring structure, or in a cyclobutene ring; and the reaction is continued until the prepolymer has a viscosity of 300 to 3,000 centipoise at 100° C and has 65% to about 75% of the available ≡SiH groups of the cyclic polysiloxane reacted.

In the prepregs prepared by the process according to the invention, the resin viscosity is maintained and the flow of the prepolymer during lamination can be controlled, ensuring sufficient resin in the final cured laminate. Glass, carbon (graphite), quartz, aramid and other conventional polymeric fibers are wetted very well by the liquid prepolymers, which are especially well suited for impregnating glass or other fibers for printed circuit board applications. Preferably, prepregs and laminates and printed circuit boards made from such prepregs should contain from 25 to 65 % by weight, of fibrous reinforcement, depending on the weave style of the reinforcement.

Preferably, the reaction is continued until the prepolymer has a viscosity of 700 to 2,000 centipoise at 100° C, and preferably the reaction is carried out in a hydrocarbon solvent that comprises 5% to 50% by weight of the reaction mixture, preferably 10% to 30% by weight of the mixture. The preferred hydrocarbon solvent is hexane, heptane, octane, pentane, toluene, methyl ethyl ketone, or xylene.

Also according to the invention, substantially tack-free prepregs prepared by the process according to the invention, are provided. Such prepregs, which can be readily separated after being placed in contact with each other for storage, are desirable for fabrication of printed circuit boards using conventional techniques. The coefficient of friction of a prepreg is useful in determining its tackiness. The coefficient of friction depends on the temperature, resin content, reinforcement material and amount of reinforcement. For instance, prepregs having a coefficient of friction at 20° C of 0.65 or less (preferably 0.60 or less) can be considered to be substantially tack-free. The value for any particular prepreg can easily be determined by a person skilled in the art. If removing the solvent during prepreg fabrication fails to eliminate tack, additional partial curing of the prepregs prepared by the process according to the invention will readily yield tack-free prepreg.

Also according to the invention, prepregs prepared by the above process are used to make laminates that are clad with conductive material for the manufacture of printed circuit boards.

The chain extender used in the process according to this invention is a low molecular weight polyene. preferably having a molecular weight less than 1,000, more preferably less than 500. The two carbon-carbon double bonds that are highly reactive in hydrosilation may contain other less reactive or even unreactive double-bonds, provided that those other double bonds do not interfere with the reactivity of the highly reactive ones, such as those in diallyl, divinyl or bis-norbornenyl compounds. Linear carbon moieties that have carbon-carbon double bonds in the beta or gamma position are useful in this invention because they isomerize under hydrosilation reaction conditions and react at the terminal carbon atom as if unsaturated at the alpha position.

These typically include monomers having two non-conjugated carbon-carbon double bonds, and having the general formulae:

$X_1 - R_2 - X_2$

or

$X_1 - X_2$

in which $X_1$ and $X_2$ (which may be the same or different) are selected from the group consisting of vinyl isopropenyls norbornenyl, 1-propenyl and 1-butenyl, and $R_2$ as defined below. Examples of chain exenders include 5-vinyl-2-norbornene, 5-ethylidene-2-norbornene, o-, m- or p-diisopropenylbenzene, o-, m- or p-divinylbenzene, diallyl ether, diallyl benzene, and any monomer with two or more terminal norbornenyl groups (including isomers that fit the general definition, such as dimethanohexahydronaphthalene (DMHN) or those having the following general formulae:

(I)

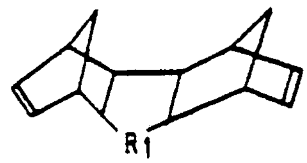

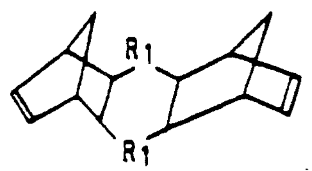

(II)

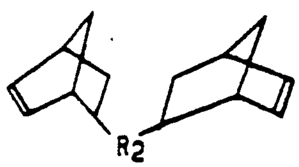

(III)

in which $R_1$, which may be the same or different in formula (II), is selected from $C(R_3)_2$, $Si(R_3)_2$, $Si(R_3)_2$-$Si(R_3)_2$, $C(R_3)_2$-$C(R_3)_2$, $CON(R_3)$, OC=O, $C(R_3)=N$, S=O, $SO_2$, O and C=O. $R_3$ is any substituent that, under the hydrosilation conditions used, does not substantially react with SiH or carbon-carbon double bonds, or interfere with hydrosilation catalysis. Illustrative are H (except when $R_3$ is attached to Si), halogen (e.g., Cl, Br, F), aromatic (e.g., aryl, aryloxy, etc.), linear, cyclic or branched aliphatic (e.g. , alkyl, cycloakyl, etc.), and may include non-hydrocarbon functional groups of many types (eg., esters, amides, ethers, ketones, halogens, etc.). (Examples of non-usable functional groups that either react with SiH or interfere with hydrosilation catalysis are olefins reactive in hydrosilation, alcohols, sulfides, some amines and phosphines). $R_1$ is preferably a hydrocarbon radical having 1 to 2 carbon atoms. Structure (I) is the symmetrical isomer of tricyclopentadiene when $R_1$ is $CH_2$. $R_2$ is an aliphatic, aromatic or siloxy radical to which may be attached functionality that, under the hydrosilation conditions used, does not substantially react with SiH or carbon-carbon double bonds, or interfere with hydrosilation catalysis. Examples of aliphatic or aromatic groups useful as $R_2$ include substituted or unsubstituted alkyl, alkoxy, aryl, and aryloxy. Examples of siloxy radicals are dimethylsiloxy, tetramethyldisiloxy, phenylmethylsiloxy and cyclosiloxanes. $R_2$ may also be a non-hydrocarbon functional group, such as esters, amides, sulfones, sulfoxides, ketones and ethers. $R_2$ is preferably a hydrocarbon radical having 1 to 6 carbon atoms or a siloxy radical having 1 to 5 silicon atoms.

Preferred chain extenders are carbon moieties that are unsubstituted in the terminal position. An example of a compound having a linear carbon moiety substituted at the beta position is 5-ethylidene-2-norbornene (the isomer of 5-vinyl-2-norbornene). Most preferred is the symmetric isomer of tricyclopentadiene.

The polycyclic polyene that comprises dicyclopentadiene may also comprise another polycyclic hydrocarbon compound having at least two non-aromatic, non-conjugated carbon-carbon double bonds, which have different chemical reactivities in their rings. They are described in the above-mentioned U.S. Patents 4,900,779 and 4,902,731. By "having at least two chemically distinguishable carbon-carbon double bonds" is meant that at least two carbon-carbon double bonds have widely different rates of reaction in hydrosilation and that one of the double bonds will react prior to substantial reaction of the other double bond(s). This first double bond must be quite reactive in hydrosilation. Reactive double bonds include those that are next to two bridgehead positions in a strained polycyclic aliphatic ring structure or in a cyclobutene

ring. The other carbon-carbon double bond(s) may be any other non-aromatic, 1,2-disubstituted non-conjugated carbon-carbon double bond that is not next to two bridgehead positions in a strained polycyclic aliphatic ring structure and is not in a cyclobutene ring. Illustrative are certain isomers of cyclopentadiene oligomers having the general formula:

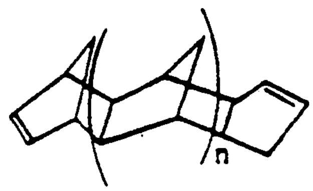

(IV)

wherein n is 1, 2 or 3 and substituted derivatives of these, in which the substituents should not substantially interfere with the reactivity of the carbon-carbon double bonds in hydrosilation and, preferably, should not be on the carbon atoms of the double bonds. Mixtures of polycyclic polymers may also be used. A mixture of dicyclopentadiene and unsymmetrical cyclopentadiene trimer is preferred.

The cyclic polysiloxanes that are reacted with the polycyclic polyene and the chain extender, also described in the above-mentioned U.S. Patents 4,900,779 and 4,902,731, have the general formula:

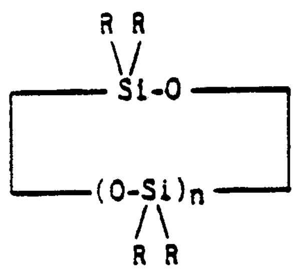

(V)

wherein R is hydrogen, or substituted or unsubstituted alkyl or aromatic radical, n is an integer from 3 to about 7, and R is hydrogen on at least three of the silicon atoms in the molecule.

Examples of reactants of Formula (V) include, e.g. tetra- and penta-methylcyclotetrasiloxanes, tetra-, penta-, hexa- and hepta-methylcyclopentasiloxanes, tetra-, penta- and hexa-methylcyclohexasiloxanes, tetraethyl cyclotetrasiloxanes and tetraphenyl cyclotetrasiloxanes. Mixtures of cyclic polysiloxanes are also useful. Preferred are 1,3,5,7-tetramethylcyclotetrasiloxane, 1,3,5,7,9-pentamethylcyclopentasiloxane and 1,3,5,7,9,11-hexamethylcyclohexasiloxane, or blends thereof.

The preferred ratio of each of the components, the polyene, the polysiloxane, and the chain extender, depends on the specific components used and the amounts thereof, and the properties desired. The specific ratios can be easily determined by a person skilled in the art according to conventional principles. As a general guide, if the components are respectively identified as (a), (b) and (c), the proportions of the components can be described as follows.

Preferably each of components (a) and (b) have two carbon-carbon double bonds, both of which are reactive in hydrosilation. In that case, the components (a), (b) and (c) should generally be present in an amount such that:

$$0.5 \leq \frac{\text{moles of double bonds in (a) and (c)}}{\text{moles of SiH bonds in (b)}} \leq 1.8$$

and

$$0.02 \leq \frac{\text{moles of double bonds in (c)}}{\text{moles of SiH bonds in (b)}} \leq 0.9.$$

Preferably, for printed circuit board applications they are in an amount such that:

$$0.7 \leq \frac{\text{moles of double bonds in (a) and (c)}}{\text{moles of SiH bonds in (b)}} \leq 1.3$$

and

$$0.02 \leq \frac{\text{moles of double bonds in (c)}}{\text{moles of SiH bonds in (b)}} \leq 0.4.$$

And, most preferably for printed circuit board applications, they are in an amount such that:

$$0.9 \leq \frac{\text{moles of double bonds in (a) and (c)}}{\text{moles of SiH bonds in (b)}} \leq 1.2$$

and

$$0.04 \leq \frac{\text{moles of double bonds in (c)}}{\text{moles of SiH bonds in (b)}} \leq 0.25.$$

For instance, to obtain substantially tack-free prepregs, if component (a) is dicyclopentadiene, component (b) is a mixture of methyl hydrocyclosiloxanes, and component (c) is 5-vinyl-2-norbornene, the ratio of double bonds in (a) and (c) to SiH bonds in (b) preferably is greater than about 1.1:1, more preferably in the range of 1.1:1 to 1.2:1. However, if component (a) is a combination of dicyclopentadiene and the unsymmetrical isomer of tricyclopentadiene, component (b) is a mixture of methylhydrocyclosiloxanest and component (c) (the chain extender) is the symmetrical isomer of tricyclopentadiene, a non-tacky product will be be achieved when the ratio of carbon-carbon double bonds to SiH bonds is in the range of 0.8:1 to 1.2:1, depending on the amount of tricyclopentadiene in the prepolymer. At a tricyclopentadiene level of about 15-35%., by weight of the prepolymer, the ratio of carbon-carbon double bonds to SiH bonds is preferably about 1:1. (It is noted that tricyclopentadiene is generally formed as a mixture of the two isomers).

The prepolymers, prepregs, polymers, etc., are usually prepared with from 0.5 to 3.0 weight % of an antioxidant to protect the prepolymer from oxidizing during formation of the prepreg, during final cure, and also to protect the final product during use, for example, as a printed circuit board. Preferred are bis-(1,2,2,6,6-pentamethyl-4-piperidinyl)-(3,5-di-tert-butyl-4-hydroxybenzyl)butylpropanedioate, (available as Tinuvin™ 144 from Ciba-Geigy Corp., Hawthorne, NY) or a combination of octadecyl 3,5-di-tert-butyl-4-hydroxyhydrocinnamate (also known as octadecyl 3-(3′,5′-di-tert-butyl-4′- hydroxyphenyl) propionate), available as Naugard™ 76 from Uniroyal Chemical Co., Middlebury, CT) and bis(1,2,2,6,6-pentamethyl-4-piperidinylsebacate) (available as Tinuvin 765™ from Ciba-Geigy Corp.).

Preferably, in the first steps of preparing prepregs for printed circuit board applications, a viscous liquid, semisolid or solid prepolymer is formed in a solvent by partially hydrosilating the three reactants in the presence of a hydrosilation catalyst until all of the more reactive double bonds (typically, half of the double bonds of the polycyclic polyene and all of the double bonds in the chain extender) are hydrosilated.

In a preferred embodiment of the process according to the invention, a platinum-containing catalyst, preferably chloroplatinic acid, and a liquid polycyclic polyene are mixed and heated at 40 to 80 °C for one to two hours to form a platinum/olefin complex. The platinum/olefin complex solution is cooled to room temperature and then mixed with the other ingredients, i.e., cyclic siloxane, polycyclic polyene, chain extender, aliphatic hydrocarbon solvent and optional ingredients. This mixture is stirred at 20 to 40 °C in a water bath that serves as a heat sink. The level of solvent (from 5 to 50% by weight of the prepolymer solution), the catalyst level, and the temperature of the bath will all affect the rate of reaction. Conditions should be chosen such that the reaction temperature does not increase substantially above the bath temperature, as a sudden temperature rise may decrease the activity of the catalyst, which is needed for cure.

In a second embodiment, the polycyclic polyene-platinum catalyst complex can be mixed with solvent, polycyclic polyene, chain extender and optional ingredients. The mixture is heated to a temperature at which hydrosilation of reactive double bonds is facile, usually 40 to 80 °C. Then, the cyclic siloxane is slowly dripped into the mixture.

In a third embodiment of the process, the solvent is heated to 50 to 80 °C. Then, the cyclic siloxane

and antioxidant are dripped into the solvent simultaneously with the polycyclic polyene- platinum complex, polycyclic polyene and chain extender.

In the more preferred process, the cyclic siloxane is mixed with solvent and antioxidant, and then heated to 50 to 80 °C. The polycyclic polyene-platinum complex, polycyclic polyene, chain extender and optional ingredients are premixed and slowly dripped into the mixture.

As indicated, the prepolymer (whose viscosity increases with the level of chain extender) is most preferably prepared in from 10 to 30%, by weight of the prepolymer, of a hydrocarbon solvent (e.g., hexane, heptane, octane, pentane, toluene, xylene, etc.) to make the prepolymer sufficiently fluid to coat the fibrous reinforcement evenly and with the proper amount of resin. Solvent can be added or stripped to obtain the desired viscosity.

All of the hydrosilation steps are carried out using a hydrosilation catalyst, preferably a platinum containing catalyst. Typical platinum concentrations are from about 0.001 to about 0.05 weight percent, preferably 0.0025 to 0.03 weight percent, based on weight of the prepolymer. The preferred catalyst for hydrosilation, in terms of both reactivity and cost, is chloroplatinic acid ($H_2PtCl_6.6H_2O$). Other platinum compounds can also be used to advantage in some instances, such as $PtCl_2$ and platinum metal on carbon. Commercially available platinum containing catalysts include PC072, PC075 and PC085, available from Huls America, Bristol, PA (formerly called Petrarch).

Conventional additives such as fillers and pigments can of course be used, such as vermiculite, mica, wollastonite, calcium carbonate, sand, silica, fumed silica, ceramic beads, hollow glass, glass spheres, glass beads, ground glass, waste glass and other mineral fillers. Fillers can serve as reinforcement, as extenders to reduce the cost, or to modify the viscosity. Fillers can be present in amounts up to about 15 weight % in glass fabric reinforced prepregs and up to about 85 weight percent when glass fibers are not used.

According to one method for forming a prepreg, a prepolymer-solvent solution is poured into a container and reinforcement fibers, e.g., glass fabric is pulled through the resin solution. In order to ensure that the final product has a uniform coating, the impregnated glass fibers are then pulled through two bars separated by shims of, for example, 10-20 mils in thickness, to remove excess resin. The impregnated glass is then hung in an oven at an elevated temperature, typically about 120 to about 160 °C (at these temperatures the less reactive carbon-carbon double bonds begin to undergo hydrosilation), for about 2 to about 5 minutes, after which it is removed and allowed to cool to a substantially tack-free prepreg comprising "the partial hydrosilation reaction product" of the three reactants. When used to refer to a prepreg, "the partial hydrosilation reaction product" means that 65 to about 75% of the Si-H groups of the siloxanes are reacted.

Laminates are prepared from the prepregs by stacking individual plies of prepreg and laminating them under heat and pressure in a hydraulic press. Copper clad laminate can be made by placing copper foil next to the prepreg plies during the lamination step.

Laminates made using the prepregs of this invention have several advantages over other compositions presently used for printed circuit boards. Due to the non-polar nature of the polymers formed, the electrical properties of the resulting laminates are outstanding, far superior to traditional epoxy and polyimide polymers. In addition, due to the non-polar nature of the polymer, laminates pick up little to no moisture during laminate and circuit board fabrication and use. Moisture pick-up is a serious problem with most materials used in printed circuit boards, both during board fabrication and in the performance of the final product. Since electrical properties can be affected by absorption of moisture, the electrical properties of the polymers of this invention are much more stable in humid environments than either epoxies or polyimides.

This invention is illustrated in the following examples, wherein all parts, percentages, etc., are by weight and all weight percentages are based on the total weight of the prepolymer, unless otherwise specified.

## Catalysts

Catalyst A:

A 1,500 ppm chloroplatinic acid/dicyclopentadiene (CPA/DCPD) catalyst complex was prepared by sparging with nitrogen for five minutes in a glass container 0.150 parts CPA, and then, adding 100 parts DCPD and stirring at 50-70 °C for one hour. Afterwards, the complex was allowed to cool to room temperature. This catalyst will be referred to as Catalyst A or CPA/DCPD catalyst complex.

Catalyst B:

Catalyst B is a commercially available catalyst, PC075, from Huls America.

## Example 1

This example demonstrates preparation of prepolymer, forming prepregs from the prepolymer, and making laminates from the prepregs.

Into a glass container were added, 53.4 parts methylhydrocyclosiloxanes (a mixture of predominantly 8, 10 and 12 membered siloxane rings) (MHCS), 40.6 parts dicyclopentadiene (DCPD), 10.4 parts 5-vinyl-2-norbornene, 1.11 parts Tinuvin™ 144 as an antioxidant, 36 parts hexane and 7.50 parts catalyst A (CPA/DCPD complex). The container was placed in a large 25 °C water bath (so that the temperature of the reaction mixture was maintained within the range of 1-5 °C above bath temperature) and stirring was carried out until all the more reactive double bonds (half of the double bonds of the polycyclic polyene and all of the double bonds in the chain extender) were hydrosilated. Of the available SiH bonds, 22% reacted with the carbon-carbon double bonds of the chain extender (5-vinyl-2-norbornene).

The gel time of the resultant prepolymer solution was measured by placing 3-4 drops of the solution directly onto a 165 °C hot plate and stirring the solution with a wooden applicator stick until it gelled. It was found to be 4 minutes, 10 seconds.

The prepolymer solution was poured into a stainless steel container equipped with two bars above the container. The bars were separated by shims 12 mils thick. Glass fabric was pulled through the resin solution and between the bars to remove excess prepolymer. Next, the impregnated glass was hung in an oven at 150 °C for approximately 150-175 seconds, after which it was removed and allowed to cool. The resultant prepreg was substantially tack free and contained about 45% weight percent prepolymer.

Two four layer laminates were prepared by stacking prepregs between Teflon sheets and aluminum caul plates and placing the stack into a room temperature press at 1,000 pounds. The press was heated to 165 °C, held for 1 hour, and, then, cooled. The laminates were then post-cured at 200 °C in a nitrogen sparged oven for 2 hours. The glass transition temperature (Tg) of the laminates, measured by a Rheometric Dynamic Spectrometer (Rheometrics Incorporated) was 132 °C. Flex strengths ranged from 25 to 28 Kpsi (kilo (1000) pounds per square inch), and flex moduli ranged from 2.2 to 2.7 Mpsi (mega (1,000,000) pounds per square inch).

## Example 2

This example demonstrates preparation of prepolymer and forming prepregs from the prepolymer using the procedures of Example 1.

A prepolymer was prepared using 53.4 parts MHCS, 44.8 parts DCPD, 7.12 parts 5-vinyl-2-norbornene, 1.13 parts Tinuvin™ 144 as an antioxidant, 37 parts hexane and 7.5 parts catalyst A (CPA DCPD complex). The gel point of the prepolymer was 4 minutes, 30 seconds at 161 °C. Glass fabric coated with the prepolymer was substantially tack-free after heating for 3 minutes, 30 seconds at 161 °C.

## Example 3

This example demonstrates preparation of prepolymer and forming prepregs from the prepolymer using the procedures of Example 1.

A prepolymer was prepared using 53.4 parts MHCS, 49.8 parts DCPD, 4.75 parts 5-vinyl-2-norbornene, 1.16 parts Tinuvin™ 144 as an antioxidant, 38 parts hexane and 7.7 parts catalyst A (CPA/DCPD complex). The gel point of the prepolymer was 5 minutes, 15 seconds at 155 °C. Glass fabric coated with the prepolymer was substantially tack-free after heating for 3 minutes, 30 seconds at 160 °C.

## Example 4

This example demonstrates preparation of prepolymer, forming prepregs from the prepolymer, and making laminates from the prepregs using the procedures of Example 1.

A prepolymer was prepared using 50 parts MHCS, 55 parts DCPD, 2.4 parts 5-vinyl-2-norbornene, 1.15 parts Tinuvin™ 144 as an antioxidant, 66 parts hexane and 7.7 parts catalyst A (CPA/DCPD complex). Some hexane was stripped to yield a 200 cps solution. The gel time of the resultant prepolymer was measured to be 7 minutes at 180° C.

Prepregs made from this prepolymer solution contained from 38-39 weight % prepolymer and were completely non-tacky. However, laminates made from these prepregs showed excessive flow, indicative of how such a low level of chain extender (5-vinyl-2-norbornene) gives insufficient molecular weight build up for proper flow during lamination.

## Example 5

This example demonstrates preparation of prepolymer, forming prepregs from the prepolymer, and making laminates from the prepregs using the procedures of Example 1.

A prepolymer was prepared using 53.4 parts MHCS, 44.4 parts DCPD, 11.3 parts m-diisopropenylbenzene, 1.17 parts Tinuvin™ 144 as an antioxidant, 39 parts hexane and 7.8 parts catalyst A (CPA/DCPD complex). Hexane was stripped until the viscosity was 250 cps. Substantially tack-free prepregs were prepared with heating for 3 minutes, 10 seconds at 132° C. The prepregs contained from 47-50 weight % of the prepolymer.

Lamination was carried out at 130° C, 300 psi for 1 hour. The laminates were post-cured for 2 hours at 200° C and contained 46-50 weight % polymer. Glass transition temperature was 138° C using a Rheometric Dynamic Spectrometer. Flexural strength and modulus were 28 Kpsi and 2.3 Mpsi, respectively.

## Example 6

This example demonstrates preparation of prepolymer and forming prepregs from the prepolymer using the procedures of Example 1.

A prepolymer was prepared using 36 parts MHCS, 35.4 parts DCPD, 6.3 parts diallyl ether, 0.78 parts Tinuvin™ 144 as an antioxidant, 19.6 parts hexane and 0.026 parts catalyst B. Gel time was measured to be 2 minutes, 37 seconds at 140° C. The resultant prepregs were slightly tacky.

## Example 7

This example demonstrates preparation of prepolymer, forming prepregs from the prepolymer and preparing a laminate from the prepregs using the procedures of Example 1.

A prepolymer was prepared using 90.0 parts MHCS, 76.7 parts DCPD, 29.8 parts cyclopentadiene trimer 5.1 parts symmetrical isomer, 24.7 parts unsymmetrical isomer), 1.97 parts Tinuvin™ 144 as an antioxidant, 22.1 parts hexane and 0.20 parts catalyst B. Once the prepolymer was made, an extra 0.10 parts of catalyst B were added to the prepolymer. Then, its gel time was measured to be 5 minutes, 15 seconds at 134° C.

Three different prepregs were prepared by heating the prepolymer on the glass fabric to 135° C for 4 minutes, 5 seconds; 3 minutes, 35 seconds; and 2 minutes, 5 seconds, respectively, and all three were found to be substantially tack-free.

Laminates were prepared and post-cured at 220° C, for 4 hours. They were found to be of good quality (uniform appearance and adequate resin content). The Tg measured by a Rheometric Dynamic Spectrometer was 188° C. The Tg measured using a Thermal Mechanical Analyzer was 150° C. Flex strength was 29.0 Kpsi and flex modulus was 1.87 Mpsi.

## Example 8

This example demonstrates preparation of prepolymer, forming prepregs from the prepolymer and preparing a laminate from the prepregs using the procedures of Example 1.

A prepolymer was prepared using 86.8 parts MHCS, 25.2 parts DCPD, 76.6 parts cyclopentadiene trimer (13.0 parts symmetrical isomer, 63.6 parts unsymmetrical isomer), 1.9 parts TinuvinTM 144 as an antioxidant, 48.3 parts toluene and 9.6 parts catalyst A. The prepolymer had a gel time of 4 minutes at 130° C.

Prepregs were prepared and found to be substantially tack-free. Then, laminates were prepared from the prepregs with post-cure at 220° C for 4 hours. The Tg of the laminate as measured using a Rheometric Dynamic Spectrometer was 215° C and as measured using a Thermal Mechanical Analyzer was 182° C. The 90° copper peel strength was 4.5-4.6 pounds per linear inch (pli).

## Example 9

This example demonstrates preparation of prepolymer and forming prepregs from the prepolymer using the procedures of Example 1.

A prepolymer was prepared using 150.0 parts MHCS, 55.6 parts DCPD, 140.3 parts cyclopentadiene trimer (23.9 parts symmetrical isomer, 116.4 parts unsymmetrical isomer), 1.13 parts TinuvinTM 765 as an antioxidant, 5.55 parts NaugardTM 76 as an antioxidant, 92.3 parts toluene and 16.5 parts catalyst A. An additional 0.42 parts of catalyst B was added to the prepolymer prior to measuring its gel time and preparing prepregs. The gel time was measured to be 5 minutes at 130° C. Prepregs prepared from this prepolymer were substantially tack-free.

## Example 10

The coefficient of friction of a number of prepregs was compared as follows.

Coefficient of friction was measured using an instrumetors slip/peel tester model SP 101-B (Imass Inc. Hingham, MA). A 2 inch by 2 inch metal sled (weighing 200 grams) was covered with a prepreg sample and the sample was pulled across a metal surface covered with an identical prepreg sample at room temperature and at a controlled speed. The coefficient of friction is measured as the force required to pull the sled across the surface, after dividing the weight of the sled. The results are given as the average of 3 runs.

Samples 1 to 3 contained 37-40% by weight prepolymer on fiberglass mats.

Table 1

| Sample | Qualitative Tackiness | Average COF |
|---|---|---|
| 1 | Tacky | 0.69 |
| 2 | Slight tack | 0.61 |
| 3 | Non tacky | 0.53 |

A major advantage of the materials of this invention (containing a chain extender) in these applications is the ability to control molecular weight and viscosity.

While one major advantage of the prepolymers described herein is the ability to use them in the fabrication of prepreg materials that are substantially tack-free, they may also be used in the fabrication of tacky prepreg. The tackiness can be varied by controlling the degree to which the resin advances during prepreg fabrication, as well as by varying the composition. Tacky prepreg is often desired for fabrication of composite structures. These structures are commonly made by laying-up prepreg pieces to give the appropriate size and shape. The tackiness of the prepreg serves to hold the pieces in place during the lay-up operation. Once the structure is formed, it is generally cured under pressure at an elevated temperature.

## Claims

1. A process for preparing a prepreg that comprises reacting a polycyclic polyene comprising dicyclopentadiene with a cyclic polysiloxane having two or more hydrogen atoms bound to silicon, to produce a prepolymer comprising a polycyclic polyene residue and a cyclic polysiloxane residue linked through carbon-silicon bonds, impregnating a fiber reinforcing material with the prepolymer, and heating the impregnated material solution to cure the prepolymer, characterized in that the cyclic polysiloxane has three or more hydrogen atoms bound to silicon, and the polyene and the polysiloxane are reacted with a chain extender comprising at least one polyene having at least two non-aromatic, non-conjugated carbon-carbon double bonds highly reactive in hydrosilation; the carbon-carbon double bonds being either in an alpha, beta or gamma position on a linear carbon moiety, next to two bridgehead positions in a strained polycyclic aliphatic ring structure, or in a cyclobutene ring; and the reaction is continued until the prepolymer has a viscosity of 300 to 3,000 centipoise at 100° C and has 65% to about 75% of the available ≡SiH groups of the cyclic polysiloxane reacted.

2. A process for preparing a prepreg as claimed in claim 1, further characterized in that the reaction is carried out in a hydrocarbon solvent, which is evaporated by the heating step.

3. A process for preparing a prepreg as claimed in claim 2, further characterized in that the hydrocarbon solvent is hexane, heptane, octane, pentane, toluene, methyl ethyl ketone, or xylene.

4. A process for preparing a prepreg as claimed in claim 2, further characterized in that the hydrocarbon solvent comprises 10% to 30% by weight of the prepolymer solution.

5. A process for preparing a prepreg as claimed in any of the preceding claims, further characterized in that the molecular weight of the chain extender is less than 1,000.

6. A process for preparing a prepreg as claimed in claim 5, further characterized in that the molecular weight of the chain extender is less than 500.

7. A process for preparing a prepreg as claimed in claim 5, further characterized in that the chain extender is a diallyl, divinyl or bis-norbornenyl compound.

8. A process for preparing a prepreg as claimed in claim 5, further characterized in that the chain extender is 5-vinyl-2-norbornene, 5-ethylidene-2-norbornene, or the symmetrical isomer of tricyclopentadiene.

9. A process for preparing a prepreg as claimed in any of the preceding claims, further characterized in that each of the polyene (a) and the polysiloxane (b) have two carbon-carbon double bonds, both of which are reactive in hydrosilation, and the respective proportions of the polyene (a), the polysiloxane (b), and the chain extender (c), are such that:

$$0.5 \leq \frac{\text{moles of double bonds in (a) and (c)}}{\text{moles of SiH bonds in (b)}} \leq 1.8$$

and

$$0.02 \leq \frac{\text{moles of double bonds in (c)}}{\text{moles of SiH bonds in (b)}} \leq 0.9.$$

10. A process for preparing a prepreg as claimed in claim 9, further characterized in that the polyene (a) is dicyclopentadiene and the chain extender (c) is 5-vinyl-2-norbornene.

11. A process for preparing a prepreg as claimed in any of the preceding claims, further characterized in that the ratio of double bonds in the polyene (a) and the chain extender (c) to SiH bonds in the polysiloxane (b) is greater than about 1.1:1.

12. A process for preparing a prepreg as claimed in claim 10, further characterized in that the ratio of double bonds in the polyene (a) and the chain extender (c) to SiH bonds in the polysiloxane (b) is in the range of 0.8:1 to 1.2:1.

13. A process for preparing a prepreg as claimed in claim 9, further characterized in that the polyene (a) comprises a mixture of dicyclopentadiene and the unsymmetrical isomer of tricyclopentadiene, the polysiloxane (b) is a mixture of methylhydrocyclosiloxanes, and the chain extender (c) is the symmetrical isomer of tricyclopentadiene.

14. A process for preparing a prepreg as claimed in claim 12, further characterized in that the ratio of

double bonds in the polyene (a) and the chain extender (c) to SiH bonds in the polysiloxane (b) is in the range of 1.1:1 to 1.2:1.

15. A process for preparing a prepreg as claimed in claim 12 or 13, further characterized in that the proportion of tricyclopentadiene is about 15-35% by weight of the prepolymer, and the ratio of carbon-carbon double bonds to SiH bonds is about 1:1.

16. Use of any of the prepreg prepared by the process as claimed in any of the preceeding claims in a laminate that is clad with conductive material to form a printed circuit board.